# EUROPEAN PATENT APPLICATION

(11) **EP 1 035 156 A1**
(43) Date of publication of application: **13.09.2000**
(21) Application number: 98955915.8
(22) Date of filing: 25.11.1998
(51) Int. Cl.: C08J 5/24, B32B 15/08

(54) **PROCESSES FOR THE PRODUCTION OF PREPREGS AND LAMINATED SHEETS**

(30) Priority: 26.11.1997 JP 32472597; 25.12.1997 JP 35837197; 25.12.1997 JP 35837297; 26.12.1997 JP 35876997
(71) Applicant: SUMITOMO BAKELITE CO., LTD., Tokyo 140-0002 (JP)
(72) Inventor: TOMINAGA, Yasushi, Shizuoka 426-0011 (JP); NAKATA, Takahiro, Shizuoka 426-0018 (JP); KOSAKA, Wataru, Shizuoka 426-0078 (JP); NAJIMA, Kazuyuki, Shizuoka 426-0077 (JP)
(74) Representative: Vossius, Volker, Dr.
(86) International application number: JP9805294
(87) International publication number: WO9927002

(57) **Abstract**

The present invention provides a method for producing a prepreg from which a laminate stable and superior in quality can be obtained at low cost without air pollution and with saving of resources and energy, and further provides a method for producing the laminate. That is, the present invention provides a method for producing a prepreg, characterized in that a mechanical energy is applied to a mixture comprising a powdered thermosetting resin and a hardener as essential components to bring about a mechanochemical reaction, the resulting powdered resin composition, as it is, or with addition of a fine powder additive having an average particle size of 0.01-1 µm and uniform mixing of them, is allowed to be present on at least the surface of a fibrous base material, and further provides a method for producing a laminate, characterized in that one or a plurality of the prepregs obtained above are used, if necessary, a metal foil is superposed on both or one side of the prepreg(s), and these are pressed under heating.

## Description

### Technical Field

The present invention relates to a method for producing prepregs and laminates, and more particularly to a method for producing prepregs and laminates suitable as printed circuit boards used for electric equipment, electronic equipment, communication equipment, etc.

### Background Art

Regarding the printed circuit boards, demand for miniaturization and enhancement of functions increases, and, on the other hand, competition in price is keen, and, especially, as for multi-layer laminates, glass fabric-based epoxy resin laminates and laminates comprising a glass nonwoven fabric as an intermediate layer base material and a glass woven fabric as a surface layer base material which are used for printed circuit boards, a great task is to reduce the price. Hitherto, a large amount of solvents have been used for the production of prepregs or laminates used therefor. This is because resin varnishes can be easily prepared, and can be easily and uniformly coated on or impregnated into base materials. The solvents are evaporated at the drying step after coating or impregnation and are not present in the products, and most of them are disposed of by combustion apparatus or released into the atmosphere as they are. For this reason, it has been pointed out that this is a cause for the warming of the earth and air pollution. On the other hand, it has been attempted to reduce the amount of solvents, but this has been difficult because of the problems in production such as coating and impregnation of the base with resins.

For the production of prepregs and laminates without using solvents, it has been studied to mix resins of low melting point or liquid resins with heating to obtain a homogeneous mixture and coat the mixture on a base. However, this suffers from the problems that sufficiently homogeneous mixture cannot be obtained, the resin sticks to apparatuses owing to decrease of heating temperature in continuous production, and the thermosetting resin gels during heating, which require cleaning of the apparatuses. Thus, continuous production has been difficult.

A proposal has been made to coat a powdered resin as it is (JP-A-50-143870), but uniform mixing and coating are difficult and partial hardening or insufficient impregnation into the base material is caused. Accordingly, this method has not yet been practically employed.

### Disclosure of Invention

As a result of research conducted in an attempt to obtain prepregs from resins using no solvent, which has been difficult, and to obtain laminates using the prepregs, it has been found that uniform mixing and impregnation into a base can be performed equivalently to the conventional method of using solvents by using a powdered resin and a hardener and subjecting the powder to a mechanochemical reaction. Research has been further conducted to accomplish the present invention.

The present invention relates to a method for producing a prepreg, characterized in that a powdered thermosetting resin and a hardener are used as essential components, and a powdered resin composition (herein-after referred to as "powder composition") obtained by applying a mechanical energy to the above components to bring about a mechanochemical reaction is allowed to be present on at least the surface of a fibrous base material (hereinafter referred to as "base"), and, furthermore, relates to a method for producing a prepreg, characterized in that a powder composition obtained by adding a fine powder additive of 0.01-1 µm in average particle size to the above-obtained powder composition and uniformly mixing them is allowed to be present on at least the surface of a base. The present invention further relates to a method for producing a laminate, characterized by heating and pressing one or more of the prepregs obtained above, if necessary, with a metal foil superposed on one or both sides of the prepreg(s).

### Brief Description of Drawing

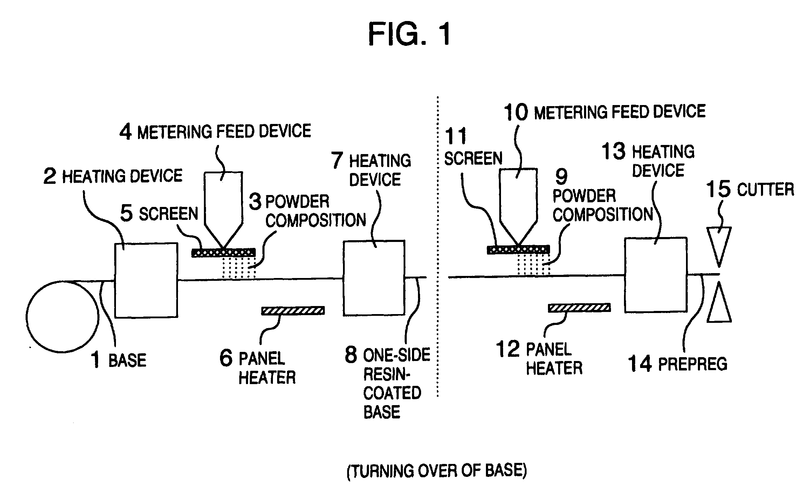

FIG. 1 is a diagram which schematically shows an example of various steps of the method for the production of prepregs according to the present invention.

### Detailed Description of the Invention

The powdered thermosetting resin used in the present invention is preferably an epoxy resin, and, a polyimide resin, a polyester resin, a phenolic resin, etc. can also be used.

When the thermosetting resin is an epoxy resin, dicyandiamide, an aromatic amine, a novolak type phenolic resin or the like is preferred as the hardener from the points of heat resistance and electric properties. An acid anhydride, an imidazole compound or the like can also be used. The hardener is preferably in the form of powder, but when the amount thereof is small (for example, less than 20% by weight based on the resin), it may be liquid as far as the mixture with the resin after application of mechanical energy can be powdered. Moreover, preferably a hardening accelerator is used. The hardening accelerator is also preferably in the form of powder, but similarly a liquid hardening accelerator can be used. The hardening accelerator includes an imidazole compound, a tertiary amine or the like. These components are not limited to those exemplified above.

The particle size of these powders is usually 1000 µm or less, preferably 0.1-500 µm, more preferably 0.1-200 µm. If it exceeds 1000 µm, the surface area per the weight of particle is small to decrease contact points of the respective components such as the thermo-setting resin, hardener, and hardening accelerator, and uniform dispersion becomes difficult. Thus, there is the possibility that reaction takes place at a ratio different from the target ratio of reaction or uniform reaction cannot be performed. When the hardener and/or hardening accelerator are in the form of powder, particle size of the thermosetting resin is preferably 5-15 times that of the hardener and/or hardening accelerator for carrying out mechanochemical reaction. This is because the hardener and/or the hardening accelerator are readily fused with the thermosetting resin in the above range.

Modification by the mechanochemical reaction is explained as follows: "This is a modification of a solid with a solid which utilizes surface activity and surface charge of particles caused by grinding, attrition, friction or contacting. There are the cases where the activity per se results in modification of dissolution rate and thermal decomposition rate due to transition of crystal form or increase of strain energy or results in mechanical strength or magnetic characteristics and where the surface activity is used for reaction with other materials or adhering to other materials. In engineering, mechanical striking energy is utilized, and not only physical modification, but also chemical modification are performed, such as generation of charge by friction or contact, adhering by magnetism, embedding of a modifier into nuclear matters and formation of film by melting." ("Comprehensive Practical Surface Modification Technique (Jitsuyo Hyomen Kaishitsu Gijutsu Soran)", p786, edited by Zairyo Gijutsu Kenkyu Kyokai and published by Sangyo Gijutsu Service Center Co., Ltd. on March 25, 1993). The present invention utilizes chemical modification by mechanochemical reaction, which includes chemical modification of solid and liquid by mechanical energy.

The powder-treating methods for giving mechanical energy to bring about mechanochemical reaction include mixing or kneading carried out by using mortar, Henschel mixer, planetary mixer, ball mill, jet mill, ang mill, multiple millstone mortar type kneading extruder, etc. Among them, preferred are mixing and kneading using ang mill (such as mechano-fusion system, manufactured by Hosokawa Micron Co., Ltd.), multiple millstone mortar type kneading extruder (such as mechanochemical dispersion system, manufactured by KCK Co., Ltd.) and jet mill (such as hybridizer system, manufactured by Nara Kikai Seisakusho Co., Ltd.), and the multiple millstone mortar type kneading extruder (such as mechanochemical dispersion system, manufactured by KCK Co., Ltd.) is especially preferred for carrying out efficient mechanochemical reaction.

For carrying out the mechanochemical reaction, softening point of the thermosetting resins is preferably 50°C or higher, more preferably 70°C or higher, further preferably 80°C or higher. This is because a heat of about 20-50°C is generated by friction, grinding or fusion between powders or powder and treating apparatus at the time of the treating, and the influence thereof must be minimized. When the softening point is too high, it is difficult to carry out effective mechanochemical reaction, and, besides, impregnation of the resin composition into the base in the subsequent step becomes difficult. Accordingly, the softening point is preferably 150°C or lower.

The components such as powdered thermosetting resin and hardener are preferably ground to the afore-mentioned particle size and then mixed as uniformly as possible by Henschel mixer or the like before subjecting to the powder treatment for the mechanochemical reaction.

If necessary, inorganic fillers may be added to the thermosetting resin composition used in the present invention. Addition of the inorganic fillers can impart properties such as tracking resistance, heat resistance and reduction in coefficient of thermal expansion. Examples of the inorganic fillers are aluminum hydroxide, magnesium hydroxide, calcium carbonate, talc, wollastonite, alumina, silica, uncalcined clay, calcined clay and barium sulfate. Particle size of these inorganic fillers is also the same as mentioned above.

Particle size of the powder composition which has been subjected to mechanochemical reaction by the powder treatment is usually 1000 µm or less, preferably 0.1-500 µm, further preferably 0.1-200 µm. This particle size is suitable for improving flowability of the powder composition at the time of spraying or coating, flowability or surface smoothness at the time of melting with heating, and, furthermore, impregnation of the resin composition into the base, and for stabilizing distribution of the resin composition in the base.

Thereafter, the powder composition, as it is, is allowed to be present on at least the surface of the base to obtain a prepreg or a fine powder additive of 0.01-1 µm in average particle size is added to the powder composition, followed by uniformly mixing them and this is allowed to be present on at least the surface of the base to obtain a prepreg. This fine powder additive can be previously mixed with the thermosetting resin and the hardener, followed by mixing them to obtain the desired effect, but the greater effect can be obtained by adding the additive to the powder composition which has been subjected to mechanochemical reaction as mentioned above.

The fluidity characteristics of the powder composition can be markedly improved by adding the fine powder additive to the powder composition. Accordingly, when the powder composition is coated on and impregnated into the base, the powder composition can be sprayed or coated uniformly on the base, and thus uniform distribution of the powder composition on the base and smoothness of the surface of the coating of the powder composition can be obtained. In this way, uniform coating on and impregnation into the base becomes possible. As the fine powder additives, inorganic fine powders are preferred, but organic powders can also be used. As for the particle size, those of 0.01-1 µm in average particle size are used, and preferably those of 0.01-0.1 µm (specific surface area: about 50-500 m²/g) are used. These fine powder additives include silica fine powder, titanium oxide fine powder, etc. If the average particle size exceeds 1 µm, the specific surface area decreases, the number of the particles per unit weight decreases, and the difference in particle size from the powdered thermosetting resin as a main component decreases. As a result, sufficient bearing effect for the improvement of fluidity cannot sometimes be obtained. The bearing effect in the powders is that by allowing fine particles to be present between particles of relatively large particle size, movement of the particles of large particle size is made freer to improve fluidity of the powder composition as a whole.

As a method for improving fluidity of the powder composition to which the fine powder additive is added, any method can be employed as long as the fine powder additive can be uniformly mixed and dispersed. As examples, mention may be made of mixing by Henschel mixer, mortar, planetary mixer, tumbler, ball mill, etc.

The powder composition obtained in this way is allowed to be present on at least the surface of a base by spraying, coating or the like. Amount of the powder composition varies depending on the kind of fibrous material, properties and weight (per unit area) of the base, but is usually about 40-60% by weight of the base. The methods for allowing the powder composition to be present on or in the base include a method of sprinkling over the top side of the base, electrostatic coating method, fluidization dipping method, spraying method, coating method using various coaters such as knife coater and comma coater, and others, and there is no limitation.

The powder composition may be allowed to be present on one side of the base, but it is preferably allowed to be present on both sides of the base in order to balance the top and under sides with each other to avoid warping and the like. Preferably, the base is then warmed.

When the base has a thin thickness of 100 µm or less (100 g/m² or less in the case of glass fiber base), or when the powder composition is easily uniformly molten, the method of allowing the powder composition to be present on one side is sufficient, and in this case it is preferred to allow the powder composition to be present on one side of the base and then warm the side of the base opposite to the side on which the powder composition is present to a temperature higher than that of the side on which the powder composition is present. That is, in order that the powder composition is allowed to be present on the base and thereafter the composition is molten to impregnate the composition into the base, the powder composition in which air moves between powder particles more easily than in liquid resin is used, and this is allowed to be present on only one side of the base (top side), thereby to permit the air present in the powder composition or the base to escape easily from the other side (under side), and furthermore the side (under side) opposite to the side on which the powder composition is present is warmed to a temperature higher than that of the side (top side) on which the powder composition is present, thereby to provide a difference in temperature between the molten resin composition and the base, and improve impregnation property by the driving force produced by the difference in temperature.

As this method for improving the impregnation property, the base can be warmed from both sides in such a manner that the temperature of the side (under side) opposite to the side on which the powder composition is present is higher than that of the another side (top side), or only the side (under side) opposite to the side on which the powder composition is present can be warmed.

For the above reason, the warming temperature is usually 90-170°C, preferably 110-150°C for the side (under side) opposite to the side on which the powder composition is present, though it depends on the softening point of the powder composition. The warming temperature for the side on which the powder composition is present is usually 80-150°C, preferably 100-140°C.

The resin-impregnated base may be heated so as to more sufficiently impregnate the resin composition and, if necessary, to place the resin in semi-hardened state. This heating temperature is usually 100-200°C, preferably 120-190°C, but sometimes varies depending on the fluidity or hardenability of the resin composition.

Taking into consideration the impregnation property of the powder composition at the time of warming, in some cases, the desired amount of the powder composition cannot be allowed to be present only by allowing the powder composition to be on one side of the base depending on the properties and thickness of the base, and the kind and properties of the powder composition. In these cases, or for preventing the warping mentioned above, adjustment of the amount of the resin to increase the amount of the resin composition adhered is carried out after the warming step, and subsequently a step of warming the base and/or a step of heating the base are provided.

The step of adjustment of the resin amount is usually carried out on the side opposite to the side on which the powder composition is present first, but it may be carried out on both sides. This can be optionally selected depending on the kind and properties of the base or resin composition to be impregnated and quality requirements of the desired prepreg. However, the former is preferred when balance of the amounts of the composition on both sides is considered. In this case, the step of the adjustment of the resin amount is not needed to be continuous to the preceding step and can be carried out after the base has once been wound up and after a lapse of time, but a wind-up apparatus and a wind-up step are required.

In the present invention, in order to satisfactorily adhere the powder composition to the base, it is preferred to previously heat the base to 50-300°C prior to the step of allowing the powder composition to be present on the base.

In case where the base is preheated, it is also preferred to allow the powder composition to be present on one side of the base and then warm the base. As mentioned above, for this warming, when the base has a thin thickness of 100 µm or less or when the powder composition is easily uniformly molten, it is preferred to warm the side of the base opposite to the side on which the powder composition is present to a temperature higher than that of the side on which the powder composition is present. Furthermore, after the step of warming the base on which the powder composition has been present, a step of heating the base to which the resin has been adhered may be provided. If necessary, in order to adjust the amount of the resin in the base to which the powder composition has been adhered, a step of allowing the powder composition to be present and subsequently a step of heating the base are provided, after the step of warming the base on which the powder composition has been present or the step of heating the base to which the resin has been adhered.

In order that the powder composition adhered to the base is molten and impregnated into the base, the base is previously heated, whereby the powder composition is easily adhered or molten and thus can be easily impregnated into the base at the subsequent warming or heating, and besides the air present in the base or the powder composition can easily escape from the base. Furthermore, by adhering the powder composition to one side of the base and then warming the base, the powder composition is molten and impregnated into the base, and, if necessary, a step of heating the resin-impregnated base is provided to more sufficiently impregnate the composition into the base and place the resin in semi-hardened state.

The preheating temperature for the base depends on the heat capacity of the base, softening point and hardenability of the powder composition, but usually is 50-300°C. If it is lower than 50°C, the effect of the heating is small, and if it is higher than 300°C, in some cases the hardening reaction of the resin takes place to adversely affect the formability in the production of laminates. The temperature is preferably 90-200°C, more preferably 110-170°C. Within this range, the powder composition adhered to the base is molten and has a proper viscosity, and impregnation of the composition into the base and the subsequent step can be satisfactorily performed.

Concerning the base, glass fiber bases such as glass cloth and glass nonwoven fabric, woven fabrics or nonwoven fabrics comprising paper, synthetic fibers or the like, and woven fabrics, nonwoven fabrics and mats comprising metallic fibers, carbon fibers, mineral fibers or the like, may be used alone or in admixture.

One or more of the thus obtained prepregs are used. If necessary, a metal foil such as copper foil is superposed on one or both sides of the prepreg(s), followed by pressing under heating according to usual methods to make a laminate or a metal foil-clad laminate. According to the methods for the production of prepregs and laminates of the present invention, the production becomes easy by use of the powder composition without causing substantial change of performances of the resulting prepregs or laminates from those of the conventional ones. As a result saving of resources and energy due to no solvent, diminishment of air pollution, and reduction of cost can be attained.

The present invention uses powder materials (resin, hardener, etc.) and applies mechanochemical reaction to them. By employing such technique, the components can be uniformly dispersed and combined, the resulting powder composition can be uniformly distributed and smooth coated surface of the powder composition can be obtained when the composition is allowed to be present in the base and impregnated in the base, and, as a result, uniform impregnation into the base can be attained.

The representative examples of the steps of the method according to the present invention will be explained in succession referring to the accompanying drawing.

### The step of mixing the powder composition:

A powder composition comprising a powdered thermosetting resin, a hardener and, if necessary, a hardening accelerator, etc. which have been previously mixed is uniformly mixed while it is subjected to mechanochemical reaction, and, then, is charged into a metering feed device 4.

### The step of preheating the base:

A base 1 is heated to a given temperature by a heating device 2 such as a panel heater, a hot-air heater or the like. This step can be omitted.

### The step of coating the powder composition:

A given amount of the powder composition 3 subjected to mechanochemical reaction treatment is coated on the (preheated) base 1 by supplying the composition to the top side of the base through a screen 5 (or by a coater) from the metering feed device 4. In case the base is preheated, the powder composition can be adhered simultaneously to both sides of the base, but by adhering the composition to the top side, the air present in the powder composition or between the fibers can be easily released from the under side.

### The step of warming:

This is the step of warming the base onto which the powder composition is coated or adhered, by a panel heater 6, a hot-air heater or the like to melt the powder composition to sufficiently adhere it to the base. This step makes it easy to replace the air in the base with the resin composition in the subsequent step. When the powder composition is adhered to the top side of the base, impregnation of the molten resin can be improved due to the driving force generated by the difference of temperature between the molten resin and the base, if the under side is warmed to a higher temperature or only the under side is warmed.

### The step of heating:

If necessary, the base onto which the powder composition has been coated or adhered and which has been warmed, is heated by a heating device 7 to impregnate the resin into the more inner portion of the base. The heating method may be conventional one and is not limited.

### The step of adjusting the amount of resin:

When the amount of the powder composition adhered to the base is less than the desired amount, or for the prevention of warping, a step of increasing the amount of the powder composition is added after the warming or heating step. Especially, in the case of preventing the warping, in some cases, the powder composition is adhered to both sides depending on the properties of the base, though usually the powder composition is adhered to only the under side. Accordingly, for carrying out this step, generally, the base 8 with the powder composition adhered to one side, which has been heated or warmed, is turned over, and a given amount of powder composition 9 is coated on the resin-impregnated base 8 by supplying the composition to the top side of the base through a screen 11 (or by a coater) from a metering feed device 10, followed by warming using a panel heater 12, warm-air heater or the like. This warming can be omitted. In the case of employing an electrostatic coating method, fluidized bath method, or the like, the powder composition can be adhered without turning over the base.

### The step of heating:

In case the step of adjustment of the resin amount is included, a heating step is preferably provided as the next step. In this step, the resin composition is heated by a heating device 13, whereby the resin composition is more sufficiently impregnated into the base and, if necessary, the resin is brought to semi-hardened state, and thus a prepreg can be obtained. The heating method may be a conventional one as in the case of the aforementioned heating step.

### The step of cutting:

The prepreg 14 is cut to the desired length by a cutter 15 for the formation of a laminate. When the prepreg is used for continuous forming of laminate, this cutting step is omitted.

In FIG. 1, the base is moved horizontally and the whole apparatus used is a horizontal type, but it is also possible to move the base up and down, and adhere the powder composition by electrostatic spraying method or by spraying the composition to a preheated base. In this case, a vertical apparatus is employed.

### Best Mode for Carrying Out the Invention

Examples of the present invention will be specifically explained together with comparative examples.

### [Example 1] (KCK, Coater method)

100 parts by weight of a powdered epoxy resin having an average particle size of 150 µm (brominated epoxy resin Ep5048 having an epoxy equivalent of 675 manufactured by Yuka Shell Co., Ltd.), 5 parts by weight of a powdered hardener having an average particle size of 15 µm (dicyandiamide) and 1 part by weight of a powdered hardening accelerator having an average particle size of 15 µm (2-ethyl-4-methylimidazole) were premixed and then treated using a multiple millstone mortar type kneading extruder (Mechanochemical dispersion system KCK-80X2-V(6) manufactured by KCK Co., Ltd.) at a revolution number of 200 rpm for 1 minute to obtain a powdered resin composition having an average particle size of 150 µm. This powdered resin composition was uniformly coated on the top side of a glass cloth of 100 g/m² by a knife coater so as to give a resin weight of 50 g/m². Thereafter, the glass cloth was warmed from the under side for about 1 minute by a panel heater at 150°C. Then, the glass cloth was turned over and the composition was uniformly coated on the other side by a knife coater so as to give a resin weight of 50 g/m², followed by heating for 1 minute by a hot-air heater at 170°C to obtain a prepreg.

Two of the prepregs were superposed one upon the other, and then a copper foil of 18 µm thickness was superposed on the top and under sides of the superposed prepregs, followed by hot pressing for 90 minutes at a temperature of 165°C and under a pressure of 60 kg/cm² to obtain a copper-clad laminate of 0.22 mm thickness.

### [Example 2] (+ addition of Aerosil)

One part by weight of a fine powder silica having an average particle size of 0.05 µm (Aerosil #200 manufactured by Japan Aerosil Co., Ltd.) was added to 100 parts by weight of the powder composition having an average particle size of 150 µm obtained in Example 1, followed by mixing for 5 minutes by Henschel mixer at a revolution number of 500 rpm. In the same manner as in Example 1, prepregs were produced using the resulting powder composition, and then a copper-clad laminate of 0.22 mm thickness was produced using the prepregs.

### [Example 3] (Hosokawa Micron, sprinkling method)

100 parts by weight of a powdered epoxy resin having an average particle size of 150 µm (Ep5048 used above), 5 parts by weight of a powdered hardener having an average particle size of 15 µm (dicyandiamide) and 1 part by weight of a powdered hardening accelerator having an average particle size of 15 µm (2-ethyl-4-methylimidazole) were premixed and then treated using a mechanofusion machine (AM-15F manufactured by Hosokawa Micron Co., Ltd.) at a revolution number of 2000 rpm for 5 minutes to obtain a powder composition having an average particle size of 150 µm. This powder composition was uniformly sprinkled on one side of a glass cloth of 100 g/m² through a screen of 60 mesh so as to give a resin weight of 50 g/m². Thereafter, the glass cloth was warmed from both sides for 30 seconds by a hot-air heater at 170°C. Then, the glass cloth was turned over and the composition was uniformly sprinkled on the other side through a screen of 60 mesh so as to give a resin weight of 50 g/m², followed by heating for 3 minutes by a hot-air heater at 170°C to obtain a prepreg.

A copper-clad laminate of 0.22 mm thickness was produced using the resulting prepregs in the same manner as in Example 1.

### [Example 4] (A thick cloth of 180 µm thickness + Aerosil)

The powder composition obtained in Example 2 was uniformly coated on one side of a glass cloth of 210 g/m² (180 µm thickness) by a knife coater so as to give a resin weight of 90 g/m². Thereafter, the glass cloth was warmed from the under side for about 1 minute by a hot-air heater at 120°C. Then, the glass cloth was turned over and the composition was uniformly coated on the other side by a knife coater so as to give a resin weight of 90 g/m², followed by heating for 1 minute by a hot-air heater at 170°C to obtain a prepreg.

Two of the prepregs were superposed one upon the other, and then a copper foil of 18 µm thickness was superposed on the top and under sides of the superposed prepregs, followed by hot pressing for 90 minutes at a temperature of 165°C and under a pressure of 60 kg/cm² to obtain a copper-clad laminate of 0.42 mm thickness.

### [Example 5] (KCK, coater method, preheating of base)

A glass cloth of 100 g/m² was heated at 120°C for 2 minutes by a heating device. Then, the powder composition having an average particle size of 150 µm obtained in Example 1 was uniformly coated on one side of this glass cloth by a knife coater so as to give a resin weight of 50 g/m². Thereafter, in the same manner as in Example 1, a prepreg was obtained, and then a copper-clad laminate of 0.22 mm thickness was produced using the resulting prepregs.

### [Example 6] (+ addition of Aerosil)

One part by weight of a fine powder silica having an average particle size of 0.05 µm (Aerosil #200 manufactured by Japan Aerosil Co., Ltd.) was added to 100 parts by weight of the powder composition having an average particle size of 150 µm obtained in Example 1, followed by mixing for 5 minutes by Henschel mixer at a revolution number of 500 rpm. In the same manner as in Example 5, prepregs were produced using the resulting powder composition, and then a copper-clad laminate of 0.22 mm thickness was produced using the prepregs.

### [Example 7] (Preheating of base, mortar, sprinkling method)

100 parts by weight of a powdered epoxy resin having an average particle size of 150 µm (Ep5048 having an epoxy equivalent of 675), 5 parts by weight of a powdered hardener having an average particle size of 15 µm (dicyandiamide) and 1 part by weight of a powdered hardening accelerator having an average particle size of 15 µm (2-ethyl-4-methylimidazole) were premixed and then the resulting composition was treated using a mortar (manufactured by Ishikawa Kojo Co., Ltd.) at a revolution number of 100 rpm for 5 minutes.

A glass cloth of 100 g/m² was heated at 120°C for 2 minutes by a heating device. Then, the powder composition obtained by the above treatment was uniformly sprinkled on one side of the glass cloth through a screen of 60 mesh so as to give a resin weight of 50 g/m². Thereafter, the under side of the glass cloth was warmed for about 1 minute by a hot-air heater at 120°C. Then, the glass cloth was turned over and the composition was uniformly sprinkled on the other side through a screen of 60 mesh so as to give a resin weight of 50 g/m², followed by heating from both sides of the glass cloth for 1 minute by a hot-air heater at 170°C to obtain a prepreg.

Two of the prepregs were superposed one upon the other, and then a copper foil of 18 µm thickness was superposed on the top and under sides of the superposed prepregs, followed by hot pressing for 90 minutes at a temperature of 165°C and under a pressure of 60 kg/cm² to obtain a copper-clad laminate of 0.22 mm thickness.

### [Example 8] (Mortar, sprinkling method, + Aerosil)

100 parts by weight of a powdered epoxy resin having an average particle size of 150 µm (Ep5048 having an epoxy equivalent of 675), 5 parts by weight of a powdered hardener having an average particle size of 15 µm (dicyandiamide), 1 part by weight of a powdered hardening accelerator having an average particle size of 15 µm (2-ethyl-4-methylimidazole) and 1 part by weight of a fine powder silica having an average particle size of 0.05 µm (Aerosil #200 manufactured by Japan Aerosil Co., Ltd.) were premixed and the resulting composition was treated using a mortar (manufactured by Ishikawa Kojo Co., Ltd.) at a revolution number of 100 rpm for 10 minutes.

The powder composition thus treated was uniformly sprinkled on one side of a glass cloth of 100 g/m² through a screen of 60 mesh so as to give a resin weight of 50 g/m². Thereafter, the glass cloth was warmed from both sides for 30 seconds by a hot-air heater at 170°C. Then, the glass cloth was turned over and the composition was uniformly sprinkled on the other side through a screen of 60 mesh so as to give a resin weight of 50 g/m², followed by warming for 3 minute by a hot-air heater at 170°C to obtain a prepreg.

Two of the prepregs were superposed one upon the other, and then a copper foil of 18 µm thickness was superposed on the top and under sides of the superposed prepregs, followed by hot pressing for 90 minutes at a temperature of 165°C and under a pressure of 60 kg/cm² to obtain a copper-clad laminate of 0.22 mm thickness.

### [Example 9] (Novolak type phenolic resin, KCK, coater)

100 parts by weight of a powdered epoxy resin having an average particle size of 150 µm (Ep5048 having an epoxy equivalent of 675), 16 parts by weight of a powdered novolak type phenolic resin having an average particle size of 30 µm (novolak type phenolic resin PR-51470 having a phenolic hydroxyl equivalent of 105 manufactured by Sumitomo Durez Co., Ltd.) and 1 part by weight of powdered triphenylphosphine having an average particle size of 10 µm were premixed and then treated using a multiple millstone mortar type kneading extruder (Mechanochemical dispersion system KCK-80X2-V(6) manufactured by KCK Co., Ltd.) at a revolution number of 200 rpm for 1 minute to obtain a powder composition having an average particle size of 150 µm.

This powder composition was uniformly coated on the top side of a glass cloth of 100 g/m² by a knife coater so as to give a resin weight of 50 g/m². Thereafter, the glass cloth was warmed from the under side for about 1 minute by a panel heater at 150°C. Then, the glass cloth was turned over and the composition was uniformly coated on the other side by a knife coater so as to give a resin weight of 50 g/m², followed by heating for 1 minute by a hot-air heater at 170°C to obtain a prepreg.

Two of the prepregs were superposed one upon the other, and furthermore a copper foil of 18 µm thickness was superposed on each of the top and under sides of the superposed prepregs, followed by hot pressing for 60 minutes at a temperature of 175°C and under a pressure of 20 kg/cm² to obtain a copper-clad laminate of 0.22 mm thickness.

### [Example 10] (+ addition of Aerosil)

One part by weight of a fine powder silica having an average particle size of 0.05 µm (Aerosil #200 manufactured by Japan Aerosil Co., Ltd.) was added to 100 parts by weight of the powder composition having an average particle size of 150 µm obtained in Example 9, followed by mixing for 5 minutes by Henschel mixer at a revolution number of 500 rpm. In the same manner as in Example 9, prepregs were obtained using the resulting powder composition, and then a copper-clad laminate of 0.22 mm thickness was produced using the prepregs.

### [Comparative Example 1] (Powder, without mechanochemical treatment)

100 parts by weight of a powdered epoxy resin having an average particle size of 150 µm (Ep5048 having an epoxy equivalent of 675), 5 parts by weight of a powdered hardener having an average particle size of 15 µm (dicyandiamide) and 1 part by weight of a powdered hardening accelerator having an average particle size of 15 µm (2-ethyl-4-methylimidazole) were stirred and mixed by an anchor blade type stirrer at a revolution number of 70 rpm for 1 minute. In the same manner as in Example 1, prepregs were obtained using the resulting powder composition, and then a copper-clad laminate of 0.22 mm thickness was produced using the prepregs.

### [Comparative Example 2] (Hot melt method)

100 parts by weight of a powdered epoxy resin having an average particle size of 150 µm (Ep5048), 5 parts by weight of a powdered hardener having an average particle size of 15 µm (dicyandiamide) and 1 part by weight of a powdered hardening accelerator having an average particle size of 15 µm (2-ethyl-4-methyl-imidazole) were mixed, and the resulting powder composition was molten by warming at 100°C. Then, a glass cloth of 100 g/m² was dipped in the molten composition to impregnate the cloth with the composition in an amount of 100 g/m² in terms of resin solid content, followed by heating by a heating device at 170°C for 2 minutes to obtain a prepreg.

Two of the prepregs were superposed one upon the other, and furthermore a copper foil of 18 µm thickness was superposed on each of the top and under sides of the superposed prepregs, followed by hot pressing for 90 minutes at a temperature of 165°C and under a pressure of 60 kg/cm² to obtain a copper-clad laminate of 0.22 mm thickness.

### [Comparative Example 3] (Conventional impregnation method)

100 parts by weight of a powdered epoxy resin having an average particle size of 150 µm (Ep5048), 5 parts by weight of a powdered hardener having an average particle size of 15 µm (dicyandiamide) and 1 part by weight of a powdered hardening accelerator having an average particle size of 15 µm (2-ethyl-4-methyl-imidazole) were mixed, and the resulting powder composition was dissolved in 100 parts by weight of methyl cellosolve. Then, a glass cloth of 100 g/m² was dipped in the resulting varnish to impregnate the cloth with the varnish in an amount of 100 g/m² in terms of resin solid content, followed by heating by a hot-air heater at 170°C for 3 minutes to obtain a prepreg.

Two of the prepregs were superposed one upon the other, and then a copper foil of 18 µm thickness was superposed on each of the top and under sides of the superposed prepregs, followed by hot pressing for 90 minutes at a temperature of 165°C and under a pressure of 60 kg/cm² to obtain a copper-clad laminate of 0.22 mm thickness.

In the above examples and comparative examples, with regard to the prepregs the impregnation of the resin into the glass cloth was evaluated, and the laminates were subjected to evaluation of formability, tensile strength, peel strength for copper foil, solder heat resistance and insulation resistance. The results are shown in Table 1 and Table 2.

**Table 1**

| Example | 1 | 2 | 3 | 4 | 5 | 6 | 7 | 8 | 9 | 10 |
|---|---|---|---|---|---|---|---|---|---|---|
| Impregnation (void) | None | None | None | None | None | None | None | None | None | None |
| Formability | Good | Good | Good | Good | Good | Good | Good | Good | Good | Good |
| Tensile strength (MPa) | 55 | 60 | 45 | 55 | 55 | 60 | 60 | 55 | 60 | 60 |
| Peel strength for copper foil (kN/m) | 1.5 | 1.6 | 1.5 | 1.6 | 1.5 | 1.6 | 1.6 | 1.6 | 14 | 15 |
| Solder heat resistance (Blister) | None | None | None | None | None | None | None | None | None | None |
| Insulation resistance (Ω) | 10¹³ | 10¹⁴ | 10¹³ | 10¹⁴ | 10¹³ | 10¹⁴ | 10¹³ | 10¹³ | 10¹⁴ | 10¹⁴ |

**Table 2**

| Comparative Example | 1 | 2 | 3 |
|---|---|---|---|
| Impregnation (void) | Exists | Exists | None |
| Formability | White dots of heardener | Good | Good |
| Tensile strength (MPa) | 20 | 60^{*1} | 60 |
| Peel strength for copper foil (kN/m) | 0.8 | 1.4^{*1} | 1.6 |
| Solder heat resistance (Blister) | Exists | Exists | None |
| Insulation resistance (Ω) | 10¹¹ | 10¹¹ | 10¹⁴ |

| | | | |
|---|---|---|---|
| *1: Different strengths obtained partially | | | |

### Method of evaluation:

1. Impregnation property: The prepreg was observed by a microscope and it was ascertained whether voids were present or not between glass fibers.
2. Formability: The copper foil of the copper-clad laminate was subjected to etching, and it was visually observed whether hardener and others separated, and dispersibility of the resin composition was evaluated.
3. Tensile strength: The copper foil of the copper-clad laminate was subjected to etching, and the laminate was cut to 10 × 100 mm, followed by measuring the tensile strength by Tensilon.
4. Peel strength for copper foil: This was measured by JIS C6481.
5. Solder heat resistance: The laminate of 50 × 50 mm was floated on a solder bath of 260°C for 3 minutes, and it was determined whether blisters occurred.
6. Insulation resistance: This was measured by JIS C6481.

As for the production cost, since the method of the Examples did not use a solvent, the cost of the laminates obtained in the Examples could be lowered about 30-40% as compared with the laminate obtained in Comparative Example 3. Furthermore, in Comparative Example 2, viscosity of the resin increased at the step of melting the resin at 100°C, and hardening proceeded. In addition, the resin which stuck to apparatuses hardened and cleaning became difficult.

### Industrial Applicability

According to the method of the present invention, a laminate satisfactory in qualities such as electrical properties and heat resistance can be stably obtained without using organic solvents. Since organic solvents are not used, saving of resources and energy, and diminishment of air pollution can be attained, and the cost can be markedly reduced by the saving of resources and energy. Thus, the present invention is suitable as an industrial method for the production of prepregs and an industrial method for the production of laminates and metal foil-clad laminates.

The laminates or metal foil-clad laminates obtained by the present invention are suitable especially as printed circuit boards used for electrical equipment, electronic equipment, communication equipment and others, and, furthermore, they can be utilized as structural materials and interior materials for vehicles, ships, aircraft, architectural structures and others.

## Claims

1. A method for producing a prepreg, characterized by applying a mechanical energy to a mixture comprising a powdered thermosetting resin and a hardener as essential components to bring about a mechanochemical reaction and allowing the resulting powdered resin composition to be present on at least the surface of a fibrous base material.

2. A method for producing a prepreg according to claim 1 which includes steps of allowing the powdered resin composition to be present on one side of the sheet-like fibrous base and then warming the base to adhere the powdered resin composition to the fibrous base material.

3. A method for producing a prepreg according to claim 1 which includes steps of preheating the sheet-like fibrous base to 50-300°C, then allowing the powdered resin composition to be present on the fibrous base material, and warming the base to adhere the composition to the base.

4. A method for producing a prepreg according to claim 1, wherein the hardener is a powdered hardener.

5. A method for producing a prepreg according to claim 1, wherein the thermosetting resin is an epoxy resin.

6. A method for producing a prepreg according to claim 5, wherein the hardener is dicyandiamide, a novolak type phenolic resin or a mixture thereof.

7. A method for producing a prepreg, characterized by applying a mechanical energy to a mixture comprising a powdered thermosetting resin and a hardener as essential components to bring about a mechanochemical reaction, adding to the resulting powdered resin composition a fine powder additive having an average particle size of 0.01-1 µm, uniformly mixing them and allowing the resulting powdered resin composition to be present on at least the surface of a fibrous base material.

8. A method for producing a prepreg according to claim 7 which includes steps of allowing the powdered resin composition to be present on one side of the sheet-like fibrous base and then warming the base to adhere the powdered resin composition to the fibrous base material.

9. A method for producing a prepreg according to claim 7 which includes steps of preheating the sheet-like fibrous base to 50-300°C, then allowing the powdered resin composition to be present on the fibrous base material, and warming the base to adhere the composition to the base.

10. A method for producing a prepreg according to claim 7, wherein the hardener is a powdered hardener.

11. A method for producing a prepreg according to claim 7, wherein the thermosetting resin is an epoxy resin.

12. A method for producing a prepreg according to claim 11, wherein the hardener is dicyandiamide, a novolak type phenolic resin or a mixture thereof.

13. A method for producing a laminate, characterized by using one or a plurality of the prepregs obtained by the method of claims 1 to 12, optionally superposing a metal foil on both or one side of the prepreg(s), followed by heating and pressing them.
